# EUROPEAN PATENT APPLICATION

(11) **EP 2 463 694 A1**
(43) Date of publication of application: **13.06.2012**
(21) Application number: 10306391.3
(22) Date of filing: 10.12.2010
(51) Int. Cl.: G02B 6/12, H01S 5/026, H01S 5/10

(54) **A distributed feedback laser structure for a photonic integrated circuit and method of manufacturing such structure**

(71) Applicant: Alcatel Lucent, 75007 Paris (FR)
(72) Inventor: DUAN, Guang-Hua, 91767, PALAISEAU (FR); BRILLOUET, François, 91460, MARCOUSSIS (FR); LAMPONI, Marco, 91620, NOZAY (FR)
(74) Representative: Shamsaei Far, Hassan

(57) **Abstract**

A laser structure comprising a die section (2) made of III-V material and a silicon wafer (3) comprising a first waveguide (31), the structure further comprises a Bragg grating (23). The Bragg grating is located inside the die section and is configured to receive light from and transmit light to said first waveguide. A further waveguide (22) is provided in the die and forms the active waveguide of the laser. A method of manufacturing the structure is also disclosed.

## Description

A distributed feedback laser structure for a photonic integrated circuit and method of manufacturing such structure

The invention relates to optical components. In particular, the invention relates to a distributed feedback laser structure for a photonic integrated circuit and a method of manufacturing such structure in particular through wafer bonding

### BACKGROUND ART

Photonic integrated circuits (PICs) are becoming increasingly attractive for optical transmission applications. PICs typically provide a number of advantages compared to non-integrated photonic circuits (PCs) comprising discrete elements. Some of such advantages are for example low power consumption, small foot print and low cost.

Wavelength division multiplexing (WDM) is a known technology based on multiplexing multiple optical carrier signals on a single optical waveguide (for example an optical fiber) wherein different wavelengths typically carry different signals. This allows for a multiplication in capacity, in addition to enabling bidirectional communication over the same optical waveguide.

The use of PICs in WDM networks is therefore considered advantageous as it may help reduce power consumption, foot print and cost.

### SUMMARY

It is therefore desired to provide low cost, high yield, high performance PICs. Such PICs may become desirable, in particular, for use in the WDM transceivers (transmitters and receivers).

Two known photonic integration platforms are typically used, one based on InP and the other on silicon.

InP integration platform is typically based on InP and related materials such as InGaAsP and InGaAs. Such platform typically allows to achieve high performance typically due to excellent material properties for light generation, modulation and detection. However, the yield and cost still remain an important concern.

Silicon integration platform is typically based on silicon and related materials such as SiO2 and Ge (Ge considered as an element on Silicon platform). This platform typically allows to achieve high yield and low cost due to the mature industrial technology developed for CMOS and the large wafer size (8" or 12"). So this integration platform is particularly adapted for large volume market such as access networks and optical interconnect for data communications. Although, some progress has recently been reported in relation to Ge-based light sources, to the knowledge of the inventors, the solution currently known directed to making light sources based on silicon and silicon compatible materials are typically not efficient or not practical.

One known solution is based on the use of bonding of InP dies on SOI wafer, and to process InP dies to make lasers after wafer bonding. Two known kinds of single mode hybrid lasers are considered herein: (a) distributed feedback (DFB) lasers and (b) distributed Bragg reflector (DBR) lasers. Both types of lasers typically use Bragg grating on silicon waveguides.

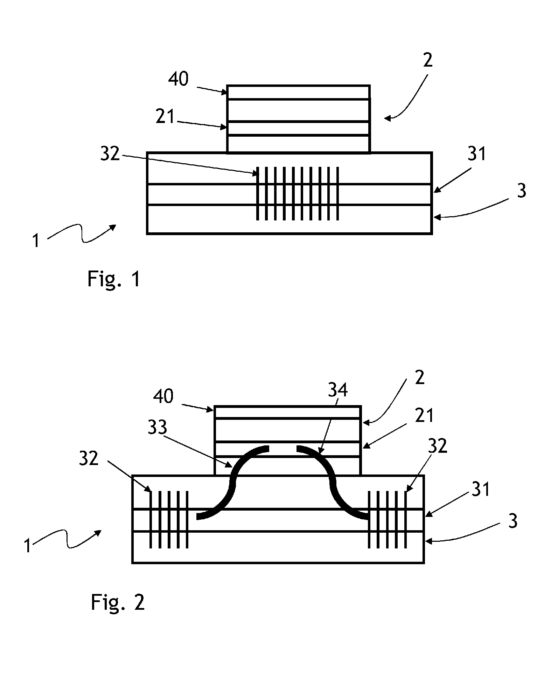

Figure 1 schematically shows an example of a DFB type laser represented by a device structure 1. The device structure 1 comprises a die section 2 and a substrate section 3. The die section 2 is typically made of III-V material such as InP material, the latter comprising a waveguide 21. The substrate section 3 typically comprises a waveguide 31 and a Bragg grating 32, preferably silicon-on-insulator (SOI) Bragg gratings. A contact layer 40 is also shown on top of die section 2. In this type of structure, the laser cavity uses hybrid mode, in which the mode typically spreads on both silicon and InP waveguides. III-V based materials typically provide optical gain, and Bragg grating in silicon typically provides distributed optical feedback, thus enabling laser action to take place. For DFB type hybrid lasers, the device performance typically depends strongly on the quality of the bonding interface as the mode spreads between III-V and silicon waveguides. Such dependence on the quality of bonding typically has a strong impact on the yield of this kind of lasers.

Figure 2 schematically shows an example of a DBR type laser. In this figure like elements have been given like reference numerals as those of figure 1. In this case, the device structure 1 also comprises a die section 2 and a substrate section 3. The die section 2 is typically made of III-V material such as InP material, the latter comprising a waveguide 21. The substrate section 3 typically comprises a waveguide 31 and a Bragg grating 32, preferably silicon-on-insulator (SOI) Bragg gratings. In this type of structure, the laser cavity uses mode transfer between the InP waveguide 21 and silicon waveguide 31 as shown by means of a first transfer path 33 and a second transfer path 34.

Both DFB and DBR structures typically allow to achieve single mode operation, i.e., emission at a single frequency. However, DFB structure is typically more appropriate for direct modulation, and DBR structure typically more appropriate to achieve wavelength tenability. However, in both structures, the laser performance is typically very sensitive to the quality of the bonding, as inside the laser cavity the laser beam typically propagates along the bonding layer in the case of DFB lasers, and typically transits from III-V waveguide to silicon waveguide through the bonding layer. Moreover, it is typically not straightforward to integrate an InP based electro-absorption modulator with these two laser structures, in particular for DBR structure.

Embodiments of the invention aim at overcoming at least some of the above-described drawbacks.

According to some embodiments there is provided a structure comprising a die section bonded on a silicon wafer, the die section being made of III-V material, the silicon wafer comprising a first waveguide, the structure further comprising a Bragg grating, wherein the Bragg grating is located inside the die section and configured to receive light from and transmit light to said first waveguide. According to some specific embodiments said die section comprises a second waveguide and the Bragg grating is configured to receive light from and transmit light to said first waveguide though said second waveguide.

According to some specific embodiments, the silicon wafer comprises a silicon on insulator structure.

According to some specific embodiments, the die section further comprises an electro-absorption modulator.

The electro-absorption modulator may have the same layer structure as that of the laser, but without etching a grating on the region corresponding to the EAM, or may have a different layer structure through the use of a butt-coupling process.

According to some specific embodiments, the structure further comprises an arrayed waveguide grating.

According to some embodiments there is provided a method of manufacturing a structure comprising a die section and a substrate section, the die section being made of III-V material, the method comprising:
- etching a Bragg grating inside the die section;
- bonding the die section on the substrate section;
- etching a waveguide in the die section;
- generating a tapering path from said waveguide in the die section to a waveguide in said silicon wafer.

According to some specific embodiments, the method further comprises obtaining an InP wafer structure by:
- growing on an InP substrate, a p-doped InGaAs contact layer;
- growing an InP p-doped cladding layer;
- growing a quaternary layer a having bandgap equivalent to about 1.17 µm;
- growing a thin InP layer, thereby producing a wafer structure comprising said layers;
- etching a grating on the resulting wafer;
- re-growing an InP p-doped layer;
- re-growing a confinement layer and multiple quantum well layers;
- re-growing a plurality of InP n-doped layers.

According to some specific embodiments, the method further comprises cleaving the InP wafer into dies and bonding the dies onto the silicon wafer.

These and further features and advantages of the present invention are described in more detail, for the purpose of illustration and not limitation, in the following description as well as in the claims with the aid of the accompanying drawings.

### BRIEF DESCRIPTION OF THE DRAWINGS

Figure 1 already discussed is a schematic cross-sectional representation of an example of a DFB type laser.
Figure 2 already discussed is a schematic cross-sectional representation of an example of a DBR type laser.
Figure 3 is a schematic cross-sectional representation of an example of a DFB type laser structure according to some embodiments.
Figure 4 is a schematic cross-sectional representation of an example of a DFB type laser structure integrated further representing an electro-absorption modulator according to some alternative embodiments.
Figure 5 is a schematic top-view representation of the DFB type laser structure according to some alterative embodiments.

### DETAILED DESCRIPTION

As already mentioned above, it is desired to provide low cost, high yield and high performance PIC structures, including in particular single mode hybrid lasers. Such a PIC structure may further comprise an electro-absorption modulator and optionally an arrayed waveguide grating (AWG).

Such structure allows for providing DFB lasers and electro-absorption modulators directly on InP waveguides. The light may be transferred from the InP waveguide to a silicon waveguide within the silicon wafer as will be described in further detail below.

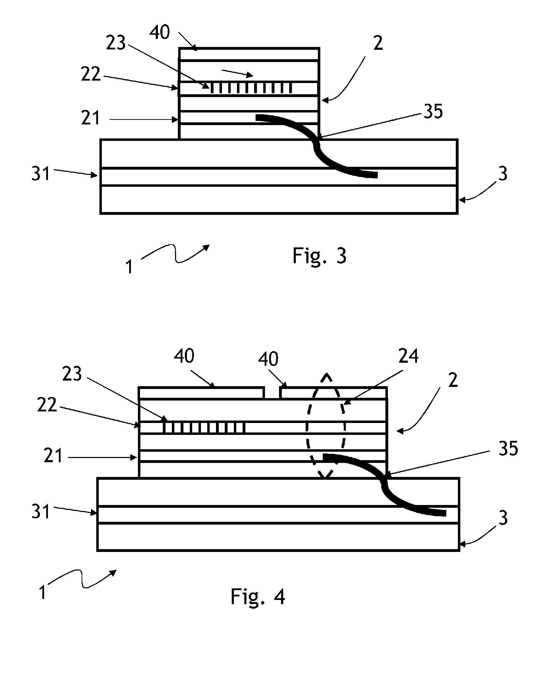

Figure 3 is a schematic cross-sectional representation of an example of a DFB type laser structure according to some embodiments. Unless otherwise indicated, in this figure like elements have been given like reference numerals as those of figure 1. It is to be noted that for the sake of simplicity only the elements or parts that are relevant for the understanding of the present description have been shown in the figure, and those with ordinary skill in the art will realize that the structure is not limited to the featured elements and may comprise other elements as required for each specific application.

Referring to figure 3, a device structure 1 is shown which comprises a die section 2. The die section 2 is typically made of III-V material such as InP material, the latter comprising a waveguide 21 also made of InP-based material. The structure 1 further comprises a silicon wafer 3 preferably comprising a silicon-on-insulator (SOI) structure. The silicon wafer 3 comprises a waveguide 31.

The die section 2 further comprises a grating layer 22 in which a Bragg grating 23 is embedded.

The die section 2, preferably of InP material, is processed after it is bonded on a SOI wafer. Processing in this case it is meant to refer to the etching of a waveguide including a taper allowing a coupling between the III-V waveguide 21 and the silicon waveguide 31, and a metallization for the electrical contact.

With this structure, light may be transferred from the InP waveguide 21 which is inside the InP structure to the silicon waveguide 31 in the silicon wafer 3. This may be done through tapers. In practice, light may be transferred from the waveguide 21 which is inside the InP section then transferred through tapers to the silicon waveguide 31 as shown by means of transfer path 35.

The Bragg grating 23 is etched inside the III-V die section 2. Different grating profiles may be used to optimize the laser performance as in a known DFB laser, for example quarter-wave phase-shift, chirped grating, and the like. As the grating is inside the III-V die section, the single mode operation of the DFB laser may be achieved substantially without any additional element on silicon wafer. Therefore, the laser performance is independent of the bonding layer. Moreover, as the lasing mode is confined in the III-V die section, it can be coupled directly to the electro-absorption modulator section without any losses. Optionally, the PIC structure may comprise an electro-absorption modulator (EAM) which is preferably integrated therein. Such integration of an EAM may allow modulation of the light generated by the laser while the entire structure is within a PIC with a relatively small size. Figure 4 is a schematic cross-sectional representation of an example of a DFB type laser structure comprising such electro-absorption modulator. Unless otherwise indicated, in this figure like elements have been given like reference numerals as those of figure 3. Here again, for the sake of simplicity only the elements or parts that are relevant for the understanding of the present description have been shown in the figure, and those with ordinary skill in the art will realize that the structure is not limited to the featured element and it may comprise other elements as needed for each specific application.

The structure of the device shown in figure 4 is similar to that of the device of figure 3 with the difference that an additional section comprising an electro-absorption modulator (EAM) is incorporated in the die section. Such additional section, i.e. EAM , is represented in figure 4 as an area shown with broken line using reference numeral 24.

Also using this structure, light may be transferred from the waveguide 21 which is inside the InP structure to the silicon waveguide 31 in the silicon wafer 3. However, in this structure, light transmitted from the waveguide 21 is first input in the EAM 24 where it may be modulated for transmission. The modulated light is then coupled through tapers to the silicon waveguide 31 as shown by means of transfer path 35.

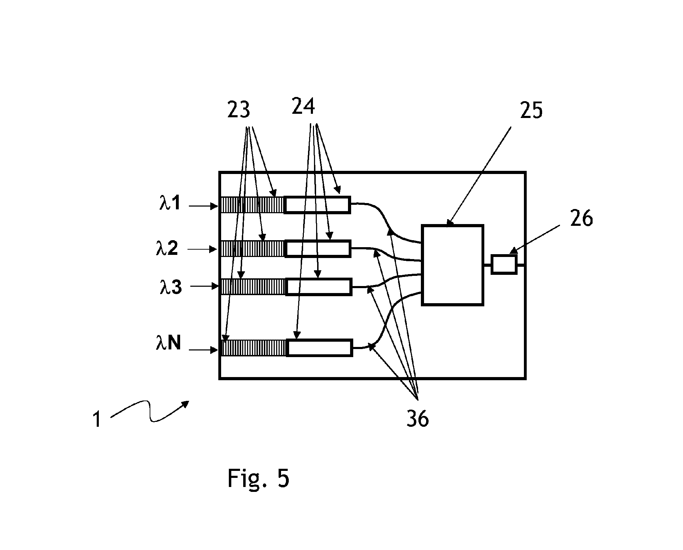

Optionally, the PIC structure may comprise an arrayed waveguide grating AWG in addition to the electro-absorption modulator which are both preferably integrated within the structure. The use of an AWG is preferred when a plurality of laser sources are provided. Namely, a plurality of Bragg gratings transmit light to corresponding EAMs. In such case, the AWG is used for multiplexing the output of the plurality of EAMs into a multiplexed optical signal for transmission. Figure 5 is a schematic top-view representation of an example of a DFB type laser structure comprising such AWG. Unless otherwise indicated, in this figure like elements have been given like reference numerals as those of figure 4. Here again, for the sake of simplicity only the elements or parts that are relevant for the understanding of the present description have been shown in the figure, and those with ordinary skill in the art will realize that the structure is not limited to the featured element and it may comprise other elements as needed for each specific application.

The structure of the device shown in figure 5 comprises a plurality of Bragg gratings each coupled to a corresponding EAM. The structure of such Bragg grating - EAM pair is similar to that of the device of figure 4. However, in figure 5 the output signals of the EAMs are coupled to an AWG 25. The AWG 25 is preferably integrated in the SOI wafer, thus in the device structure 1.

As mentioned in relation to figure 4, light may be transferred from the waveguide 21 which is inside the InP structure to the silicon waveguide 31 (figure 4) in the substrate section 3. This is done by transmitting light from the Bragg grating 23 which is first input in the EAM 24 where it may be modulated for transmission and coupled through tapers to the silicon waveguide 31 as shown by means of transfer path 35 (figure 4).

However, in this structure, a plurality of laser sources are represented which are configured to transmit light at different wavelengths, λ₁, λ₂, λ₃ to λₙ. Each single wavelength, generated by a respective laser source, through a respective Bragg grating is subsequently input into a respective EAM (generally shown in the figure by reference numeral 24). The light, after being modulated in the respective EAM is output from the latter and input, through a respective waveguide (generally shown in the figure by reference numeral 36), into the AWG 25. The AWG 25 is in charge of multiplexing the received wavelengths to generate a multi-wavelength (multiplexed) optical signal and provide the resulting optical signal at an output thereof.

Optionally a semiconductor optical amplifier (SOA) 26 may also be integrated in the device 1 in order to amplify the optical signal output from the AWG 25 before transmission. The SOA may also be realized through the bonding of InP die on a SOI wafer

The above entire structure may be integrated into a PIC thereby providing devices with reduced size and high performance.

A preferred method of producing such device structure is provided below.

An InP substrate is used as starting material over which a p-doped InGaAs contact layer is grown, then a InP p-doped layer grown over the contact layer to serve as cladding. This is followed by a quaternary layer such as InGaAsP grown over the cladding layer preferably with a bandgap equivalent to about 1.17 µm. This layer serves as a grating layer, and finally a thin InP layer serving as an interface for the re-growth. Next a grating, together with alignment marks, is etched on the grown wafer, using for example wet or dry etching. After the etching of the grating, a re-growth process is followed comprising the growth of an InP p-doped layer, a separate confinement layer, multiple quantum well layers and a second separate confinement layer, used for generation of light and guiding.

If an electro absorption modulator is also to be incorporated in the structure, said electro absorption modulator may have the same layer as the one used for the laser structure.

An alternative manner of incorporating the electro absorption modulator in the structure may be the following:
Once the steps for carrying out the method for producing the device as described above are performed, an etching process is used to eliminate quantum well layer and separate confinement layers in appropriate areas. A second selective area re-growth is then performed to grow a quantum well structure specially designed for electro-absorption modulator.

Finally, in either case of the above alternative processes of manufacturing, InP n-doped layers as cladding and a contact layer such as InGaAs for electrical injection for the laser operation are grown on the whole InP wafer.

The resulting InP wafer is cleaved into dies. The position of Bragg gratings etched on the dies is preferably accurately determined through observation of said alignment marks for example by using optical microscopy. The dies are then bonded onto a silicon substrate, preferably an SOI wafer, with an approximate alignment (for example with an accuracy of about 5 µm or less) of the Bragg gratings with respect to the silicon waveguides. The bonding is made using known techniques such as molecular bonding. Finally the dies will be processed to produce lasers and optionally modulators.

Tapered waveguide may be achieved through the variation of the III-V waveguide width, preferably by reducing the waveguide width.

The laser and modulator sections are preferably separated through the etching of the InGaAs contact layer between two electrodes and ion implantation.

The bonded InP dies may be eventually treated following an intermixing process in order to shift the bandgap of the EAM section. Preferably, on the silicon wafer, silicon waveguides for AWG and other elements such as output coupler are already made before bonding.

Such a solution thus allows to design a transmitter PIC which combines both the advantages of InP and silicon structures, namely InP for efficient light generation and modulation and silicon for compact passive wavelength multiplexing. As compared to the known solution, such device is low cost because of its small size and low power consumption.

A device according to the embodiment of figure 5 includes an array of InP based DFB lasers, an array of electro-absorption modulators and an AWG. Such a circuit may be made very (even extremely) compact with a length of about 500µm for lasers and about 300µm for modulators. The AWG on SOI may have a size of about 400x400 µm2.

Compared to the solution in which the optical mode spreads between SOI and III-V guiding layers, this proposed solution may be less sensitive to bonding defects, leading to higher yield and higher reliability.

Typically an AWG on InP platform has quite a large size due to the low index contrast in these materials. On the other hand, a silicon platform allows to fabricate very compact AWGs, but the size of modulators is very large. With the solution proposed herein, the AWG size and the modulator size are maintained low as the former is made on silicon platform and the latter is made in the InP platform.

The various embodiments of the present invention may be combined as long as such combination is compatible and/or complimentary.

Furthermore, it is to be noted that the list of structures corresponding to the claimed means is not exhaustive and that one skilled in the art understands that equivalent structures can be substituted for the recited structure without departing from the scope of the invention.

It is also to be noted that the order of the steps of the method of the invention as described and recited in the corresponding claims is not limited to the order as presented and described and may vary without departing from the scope of the invention.

It should be appreciated by those skilled in the art that any block diagrams herein represent conceptual views of illustrative circuitry embodying the principles of the invention.

## Claims

1. A structure comprising a die section and a silicon wafer, the die section being made of III-V material, the silicon wafer comprising a first waveguide, the structure further comprising a Bragg grating, wherein the Bragg grating is located inside the die section and configured to receive light from and transmit light to said first waveguide.

2. The structure of claim 1 wherein said die section comprises a second waveguide and the Bragg grating is configured to receive light from and transmit light to said first waveguide though said second waveguide.

3. The structure of claim 1 or claim 2 wherein the silicon wafer comprises a silicon in insulator structure.

4. The structure of any one of preceding claims wherein the die section further comprises an electro-absorption modulator.

5. The structure of any one of the preceding claims wherein the structure further comprises an arrayed waveguide grating.

6. A method of manufacturing a structure comprising a die section and a silicon wafer, the die section being made of III-V material, the method comprising:
- etching a Bragg grating inside the die section;
- bonding the die section on the substrate section;
- etching a waveguide in the die section;
- generating a tapering path from said waveguide in the die section to a waveguide in said silicon wafer.

7. The method of claim 6 wherein the method further comprises obtaining an InP wafer structure:
- growing on an InP substrate, a p-doped InGaAs contact layer;
- growing an InP p-doped cladding layer;
- growing a quaternary layer a having bandgap equivalent to about 1.17 µm;
- growing a thin InP layer, thereby producing a wafer structure comprising said layers;
- etching a grating on the resulting wafer;
- re-growing an InP p-doped layer;
- re-growing a confinement layer and multiple quantum well layers;
- re-growing a plurality of InP n-doped layers.

8. The method of claim 7 further comprising cleaving the InP wafer into dies and bonding the dies are then bonded onto the silicon wafer.
